# EUROPÄISCHE PATENTSCHRIFT

(11) **EP 2 608 254 B1**
(45) Veröffentlichungstag und Bekanntmachung des Hinweises auf die Patenterteilung: **27.04.2016**
(21) Anmeldenummer: 12188805.1
(22) Anmeldetag: 17.10.2012
(51) Int. Cl.: H01L 23/10, H01L 23/053

(54) **Leistungshalbleitermodul oder Ansteuermodul hierfür**
Semiconductor power module or actuation module for same
Module semi-conducteur ou module de commande pour celui-ci

(30) Priorität: 22.12.2011 DE 102011056848
(43) Veröffentlichungstag der Anmeldung: 26.06.2013
(73) Patentinhaber: SEMIKRON Elektronik GmbH & Co. KG, 90431 Nürnberg (DE)
(72) Erfinder: Popp, Rainer, 91580 Petersaurach (DE); Weiß, Stefan, 91315 Höchstadt (DE)

(56) Entgegenhaltungen:
- EP-A2- 0 237 739
- EP-A2- 2 019 424
- DE-A1- 2 501 337
- DE-A1- 10 340 974
- DE-A1-102009 037 257
- DE-B1- 1 489 097
- US-A- 2 822 512

## Beschreibung

Die Erfindung betrifft ein Leistungshalbleitermodul oder Ansteuermodul hierfür, umfassend eine Ansteuerschaltung, ggf. eine leistungselektronische Schaltung, ein Gehäuse mit einem Gehäusedeckel und vorzugsweise einer Bodenplatte, wobei der Gehäusedeckel von elektrischen Anschlüssen durchgriffen ist.

Es ist bekannt, zur Abdichtung von Einführungen elektrischer Anschlüsse in ein Leistungshalbleitermodul, wobei die Einführungen einen Dichtgrad beispielsweise IP54 aufweisen müssen, Dichtkleber oder spezielle Dichtverschraubungen einzusetzen. Das hat jedoch den Nachteil, dass zusätzliche Materialien oder Arbeitsschritte erforderlich sind, um den gewünschten Schutzgrad zu erreichen. Von weiterem Nachteil ist, dass nach der Installation des Leistungshalbleitermoduls ein hohes Restrisiko besteht, dass diese Abdichtungen nicht dauerhaft den Umgebungseinflüssen standhalten.

Die DE 1489097 beschreibt eine Halbleiter-Gleichrichterzelle, in welcher ein einziges Halbleiterelement vorgesehen ist. Dieses Halbleiterelement sitzt in einem Bodenbereich eines Gehäuses. Es ist dort zwischen zwei Edelmetallscheiben angeordnet. Zu den Edelmetallscheiben führt ein Druckstempel. In dem Gehäuse ist ein elastischer Formkörper angeordnet, der zwischen dem Stempel und einem Deckel des Gehäuses eingepresst ist, um auf das Halbleiterelement einen Kontaktdruck auszuüben. Der elastische Formkörper hat in einer Ausführung eine zylindrische Verlängerung, und durch den elastischen Formkörper mit seiner zylindrischen Verlängerung tritt ein Schaft des Stempels hindurch, sodass dieser Schaft aus dem Gehäusedeckel herausragt.

Aufgabe der vorliegenden Erfindung ist es, ein Leistungshalbleitermodul oder Ansteuermodul hierfür zu schaffen, das die Nachteile des Standes der Technik vermeidet.

Erfindungsgemäß wird diese Aufgabe mit dem Gegenstand des Anspruchs 1 gelöst. Es wird ein Leistungshalbleitermodul oder Ansteuermodul hierfür vorgeschlagen, umfassend eine Ansteuerschaltung und vorzugsweise eine leistungselektronische Schaltung und ein Gehäuse mit einem Gehäusedeckel und vorzugsweise einer Bodenplatte, wobei der Gehäusedeckel von elektrischen und/oder optischen Anschlussmitteln durchgriffen ist, wobei vorgesehen ist, dass zwischen einer oberen Stirnseite des Gehäuses und einer unteren Stirnfläche des Gehäusedeckels eine elastomere Dichtungseinrichtung angeordnet ist, die eine Grundplatte und ein oder mehrere auf der Grundplatte angeordnete, im Querschnitt jeweils trapezförmige Dichtungselemente aufweist, wobei die Dichtungselemente jeweils eine Kopfplatte mit mindestens einem Durchgangsloch aufweisen. Weiterhin korrespondieren die Dichtungselemente mit im Querschnitt trapezförmigen Ausnehmungen des Gehäusedeckels. Durch die korrespondierende trapezförmige Ausbildung liegen die Wände der Dichtungselemente nach dem Anpressen der Dichtungseinrichtung satt an der Innenseite des Gehäusedeckels an und bilden wegen der Elastizität der Dichtungseinrichtung einen dichten und dauerhaftenden Sitz.

Weiterhin sind die Dichtungselemente geschlitzt ausgebildet, wobei mindestens ein Schlitz vom Fußabschnitt des Dichtungselements ausgehend in dem mindestens einen Durchgangsloch endet. Der Schlitz erleichtert das Einführen des Anschlussmittels in das Durchgangsloch, indem der Schlitz beim Einführen aufsperrt und die Reibung in dem Durchgangsloch vermindert ist.

Das erfindungsgemäße Leistungshalbleitermodul hat den Vorteil, dass zur Montage keine zusätzlichen Mittel und/oder Werkzeuge erforderlich sind, um die elektrischen Anschlüsse abzudichten, um eine hohe Sicherheit gegen Umwelteinflüsse, beispielsweise Schutzgrad IP 54, zu erreichen. Weiter sind keine Arbeitsschritte vorgesehen, die eine besondere Sorgfalt oder eine besondere Qualifikation erfordern. Es ist lediglich die Dichtungseinrichtung zwischen Gehäuse und Gehäusedeckel einzulegen und der Gehäusedeckel auf dem Gehäuse zu befestigen, beispielsweise durch Verschrauben. Durch die Ausbildung der Dichtungseinrichtung als elastomere Dichtungseinrichtung wird eine gute Langzeitdichtwirkung erreicht.

Es kann vorgesehen sein, dass die Dichtungselemente mit der Grundplatte einstückig ausgebildet sind. Diese Ausführungsform kann bevorzugt sein, weil sie mit einem geringen Fertigungsaufwand herstellbar ist, beispielsweise durch Pressen.

Die Dichtungselemente können als Hohlkörper ausgebildet sein.

Es kann vorgesehen sein, dass die Anschlussmittel drahtförmig mit kreisförmigem Querschnitt ausgebildet sind. Die elektrischen Anschlussmittel können mit einer Isolierung ausgebildet sein. Anschlussmittel können auch als "optische" Anschlussmittel, beispielsweise als Lichtleitkabel ausgebildet sein.

In einer weiteren vorteilhaften Ausbildung kann vorgesehen sein, dass die Anschlussmittel bandförmig mit rechteckigem Querschnitt ausgebildet sind.

Es kann vorgesehen sein, dass das mindestens eine Durchgangsloch einen Querschnitt aufweist, der zu dem Querschnitt des das mindestens eine Durchgangsloch durchgreifenden Anschlussmittels korrespondiert. Es können also je nach Ausbildung des Anschlussmittels unterschiedliche Querschnittsformen vorgesehen sein, beispielsweise bei Drähten kreisförmige und bei Bändern rechteckförmige Querschnitte.

Es kann weiter vorgesehen sein, dass der Innendurchmesser des Durchgangslochs kleiner als der Außendurchmesser des Anschlussmittels ist. Das Dichtungselement liegt so im Bereich des Durchgangslochs unter elastischer Spannung satt an dem elektrischenund/oder optischen Anschlussmittel an und dichtet es dadurch ab.

Der Gehäusedeckel kann an seiner unteren Stirnseite Dichtungsstege aufweisen. Die Dichtungsstege können vorzugsweise im Fußbereich der Dichtungselemente angeordnet sein.

Die Dichtungseinrichtung kann vorzugsweise zwischen der unteren Stirnseite des Gehäusedeckels und der oberen Stirnseite des Gehäuses mit Quetschsitz angeordnet sein. Es ist aber auch möglich, dass die Dichtungseinrichtung gehäuseseitig an einer im Gehäuse angeordneten Deckplatte oder dergleichen abgestützt ist.

Das Gehäuse kann eine umlaufende Randwulst aufweisen, in deren Innenraum die Grundplatte der Dichtungseinrichtung einlegbar ist. Auf diese Weise kann die Montagesicherheit weiter erhöht werden, weil die Dichtungseinrichtung bereits vor Auflegen des Gehäusedeckels in ihrer Lage fixiert ist.

Die Erfindung wird nun anhand von Ausführungsbeispielen näher erläutert. Es zeigen
- Fig. 1: ein erstes Ausführungsbeispiel eines erfindungsgemäßen Leistungshalbleitermoduls in perspektivischer Darstellung;
- Fig. 2: einen Gehäusedeckel in Fig. 1 in perspektivischer Darstellung in der Druntersicht;
- Fig. 3: die Dichtungseinrichtung in Fig. 1 in perspektivischer Darstellung in der Draufsicht;
- Fig. 4: ein zweites Ausführungsbeispiel eines erfindungsgemäßen Leistungshalbleitermoduls in perspektivischer Explosivdarstellung;
- Fig. 5a: die Dichtungseinrichtung in Fig. 4 in perspektivischer Draufsicht;
- Fig. 5b: die Dichtungseinrichtung in Fig. 4 in perspektivischer Druntersicht.

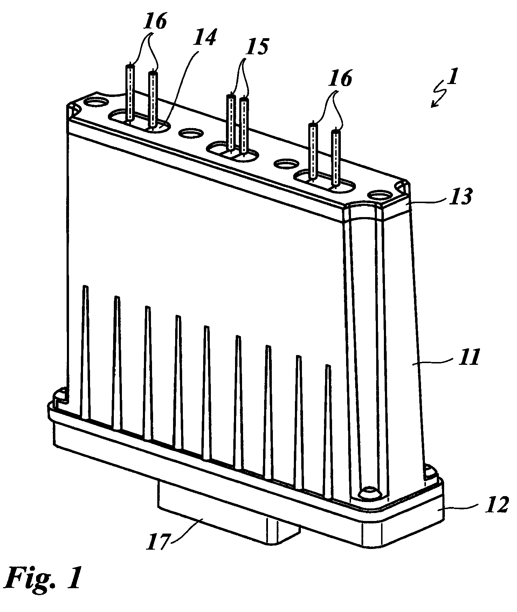

Fig. 1 zeigt ein Leistungshalbleitermodul 1 mit einer in einem Gehäuse 11 angeordneten Leistungshalbleiterschaltung, einer Bodenplatte 12 und einem Gehäusedeckel 13. Bei der Leistungshalbleiterschaltung kann es sich beispielsweise um eine flüssigkeitsgekühlte Halbbrückenschaltung handeln.

Die Bodenplatte 12 des Leistungshalbleitermoduls 1 weist an ihrer Unterseite neben einem elektrischen Steckverbinder 17 einen Einlass und einen Auslass für Kühlflüssigkeit auf. Mehrere Leistungshalbleitermodule 1 sind nebeneinander auf einer Montagefläche einer Flüssigkeitskühleinrichtung anordenbar.

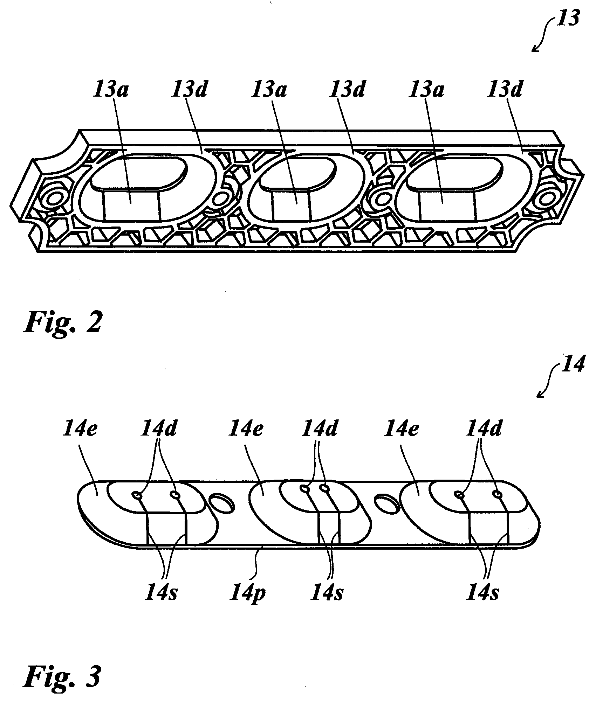

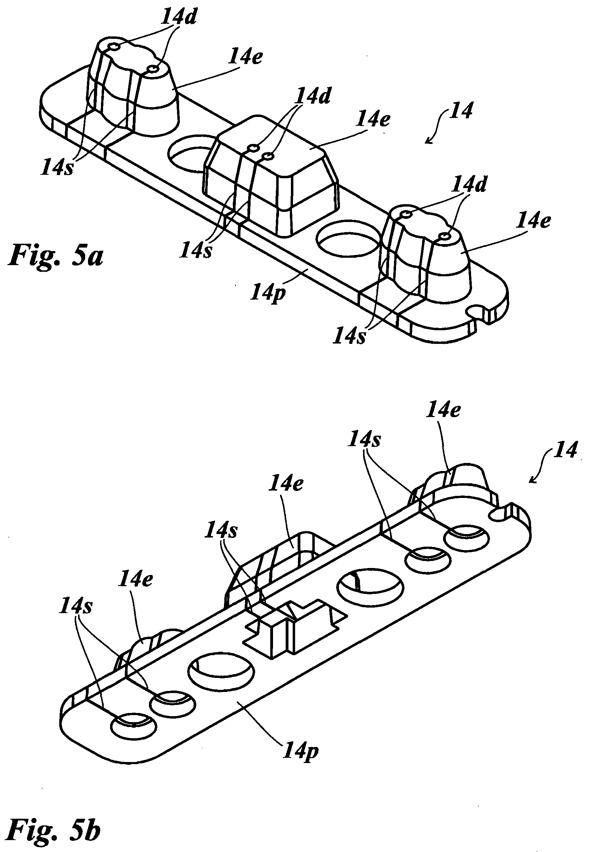

Der Gehäusedeckel 13 weist Dichtausnehmungen 13a auf, in denen Dichtungselemente 14e einer Dichtungseinrichtung 14 angeordnet sind, die in den Fig. 3 und 5 näher beschrieben ist. Die Dichtungselemente 14e weisen in einer Kopfplatte angeordnete Durchgangslöcher 14d auf, die von als elektrischen Anschlussmitteln 15 oder optischen Anschlussmitteln 16 ausgebildeten Anschlussmitteln der Leistungshalbleiterschaltung durchgriffen sind.

Die Fig. 2 und 3 zeigen den Aufbau und das Zusammenwirken des Gehäusedeckels 13, der Dichtungseinrichtung 14 und des Gehäuses 11.

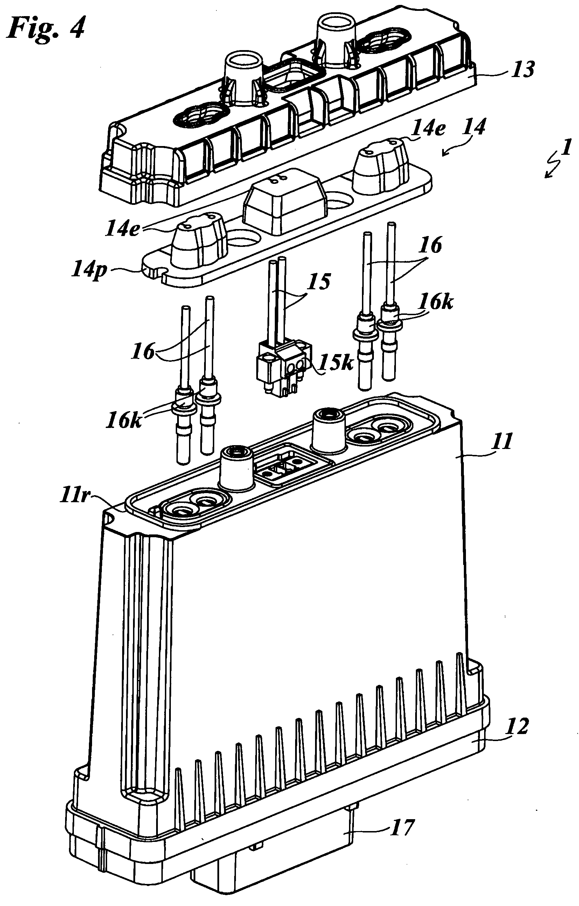

Die Dichtungseinrichtung 14 ist aus einem gummielastischen Material, beispielsweise Silikongummi, ausgebildet. Die Dichtungselemente 14e sind auf einer gemeinsamen Grundplatte 14p angeordnet, die im montierten Zustand an der Unterseite des Gehäusedeckels 13 und der oberen Stirnseite des Gehäuses 11 anliegt (siehe auch Fig. 4). Die Dichtungselemente 14e sind als im Querschnitt trapezförmige Hohlkörper ausgebildet und korrespondieren mit Dichtausnehmungen 13a im Gehäusedeckel 13. In den in Fig. 3 und 5 dargestellten Ausführungsbeispielen sind drei Dichtungselemente 14e und die Grundplatte 14p einstückig ausgebildet. Das mittlere Dichtungselement 14e ist jeweils von zwei elektrischen Anschlussmitteln 15 durchgriffen. Die beiden äußeren Dichtungselemente 14e sind jeweils von zwei optischen Anschlussmitteln 16 durchgriffen. In den in Fig. 1 und 4 dargestellten Ausführungsbeispielen des Leistungshalbleitermoduls 1 sind die elektrischen Anschlussmittel 15 und die optischen Anschlussmittel 16 als Drähte bzw. drahtförmig ausgebildet und weisen einen kreisförmigen Querschnitt auf. Es können aber auch bandförmige Anschlussmittel mit rechteckigem Querschnitt vorgesehen sein. Wesentlich ist, dass die Durchgangslöcher 14d einen Querschnitt aufweisen, der zu dem Querschnitt der Anschlussmittel 15 und 16 korrespondiert.

Wie Fig. 2 zeigt, sind die Dichtausnehmungen 13a im Gehäusedeckel 13 im Querschnitt trapezförmig ausgebildet. Die Dichtausnehmungen 13a korrespondieren mit den Dichtungseinrichtungen 14e der Dichtungseinrichtung 14. Die Dichtungseinrichtungen 14e weisen ein Übermaß zu den Innenabmessungen der Dichtausnehmungen 13a auf, so dass die Außenwand der Dichtungseinrichtung 14e im montierten Zustand satt an der Innenwand der Dichtausnehmung 13a anliegt und eine Dichtung ausbildet. Weiter sind an der Unterseite des Gehäusedeckels 13 Dichtlippen 13d vorgesehen, welche am Umfang der Dichtausnehmungen 13a erstreckt sind und im montierten Zustand auf der Oberseite der Grundplatte 14p der Dichtungseinrichtung 14 abdichtend aufliegen.

Weitere Dichtungen werden zwischen den Anschlussmitteln 15 und 16 und den Durchgangslöchern 14d ausgebildet, wobei der Innendurchmesser des Durchgangslochs 14d kleiner als der Außendurchmesser des Anschlussmittels 15, 16 ist. Bei Anschlussmitteln mit rechteckigem Querschnitt sind sinngemäß die Breite und Länge des Durchgangslochs 14d kleiner als die Dicke und Breite des Anschlussmittels 15, 16. Zur Erleichterung des Einführens der Anschlussmittel 15, 16 sind die Dichtungselemente 14e mit Schlitzen 14s ausgebildet, wobei die Schlitze 14s vom Fußabschnitt der Dichtungselemente 14e ausgehend in den Durchgangslöchern 14d enden. Die Schlitze 14s sind bei montierter Dichtungseinrichtung 14 geschlossen.

Die Fig. 4 und 5 zeigen ein zweites Ausführungsbeispiel.

Die Dichtungseinrichtung 14 in Fig. 4 und 5 ist wie die Dichtungseinrichtung in Fig. 3 ausgebildet, mit dem Unterschied, dass die Grundplatte 14p einen umlaufenden freien Randabschnitt aufweist, der an die Dichtungselemente 14e angrenzt, und dass die Außenwand der Dichtungselemente 14e zwei aneinandergrenzende Abschnitte mit unterschiedlichem Neigungswinkel umfasst.

Wie Fig. 4 zeigt, weist eine obere Stirnfläche 11 o des Gehäuses 11 eine umlaufende Randwulst 11r auf, in deren Innenraum die Grundplatte 14p der Dichtungseinrichtung 14 einlegbar ist.

Die elektrischen Anschlussmittel 15 sind in Klemmverbindern 15k geklemmt. Die optischen Anschlussmittel 16 sind in Klemmverbindern 16k geklemmt. Die Klemmverbinder 15k und 16k sind nach dem Aufsetzen der Dichtungseinrichtung 14 von den Dichtungselementen 14e überdeckt.

### Bezugszeichenliste

- 1: Leistungshalbleitermodul
- 11: Gehäuse
- 11o: obere Stirnfläche
- 11r: Randwulst
- 12: Bodenplatte
- 13: Gehäusedeckel
- 13a: Dichtausnehmung
- 13d: Dichtlippe
- 14: Dichtungseinrichtung
- 14d: Durchgangsloch
- 14e: Dichtungselement
- 14p: Grundplatte
- 14s: Schlitz
- 15: elektrisches Anschlussmittel
- 16: optisches Anschlussmittel
- 17: elektrischer Steckverbinder

## Patentansprüche

1. Leistungshalbleitermodul oder Ansteuermodul hierfür, umfassend eine leistungselektronische Schaltung und ein Gehäuse (11) mit einem Gehäusedeckel (13), wobei der Gehäusedeckel (13) von elektrischen und/oder optischen Anschlussmitteln (15, 16) durchgriffen ist,
**dadurch gekennzeichnet,**
**dass** zwischen einer oberen Stirnseite (11o) des Gehäuses (11) und einer unteren Stirnfläche des Gehäusedeckels (13) eine elastomere Dichtungseinrichtung (14) angeordnet ist, die eine Grundplatte (14p) und ein oder mehrere auf der Grundplatte (14p) angeordnete, im Querschnitt jeweils trapezförmige Dichtungselemente (14e) aufweist, wobei die Dichtungselemente (14e) mit im Querschnitt trapezförmigen Ausnehmungen des Gehäusedeckels (13) korrespondieren und jeweils eine Kopfplatte mit mindestens einem Durchgangsloch (14d) aufweisen und wobei die Dichtungselemente (14e) geschlitzt ausgebildet sind, wobei mindestens ein Schlitz (14s) vom Fußabschnitt des Dichtungselements (14e) ausgehend in dem mindestens einen Durchgangsloch (14d) endet.

2. Leistungshalbleitermodul nach Anspruch 1,
**dadurch gekennzeichnet,**
**dass** die Dichtungselemente (14e) mit der Grundplatte (14p) einstückig ausgebildet sind.

3. Leistungshalbleitermodul nach einem der vorangehenden Ansprüche,
**dadurch gekennzeichnet,**
**dass** die Dichtungselemente (14e) als Hohlkörper ausgebildet sind.

4. Leistungshalbleitermodul nach einem der vorangehenden Ansprüche,
**dadurch gekennzeichnet,**
**dass** die Anschlussmittel (15, 16) drahtförmig mit kreisförmigem Querschnitt ausgebildet sind.

5. Leistungshalbleitermodul nach einem der Ansprüche 1 bis 3,
**dadurch gekennzeichnet,**
**dass** die Anschlussmittel (15, 16) bandförmig mit rechteckigem Querschnitt ausgebildet sind.

6. Leistungshalbleitermodul nach einem der vorangehenden Ansprüche,
**dadurch gekennzeichnet,**
**dass** das mindestens eine Durchgangsloch (14d) einen Querschnitt aufweist, der zu dem Querschnitt des das mindestens eine Durchgangsloch (14d) durchgreifenden Anschlussmittels (15, 16) korrespondiert.

7. Leistungshalbleitermodul nach einem der vorangehenden Ansprüche,
**dadurch gekennzeichnet,**
**dass** der Innendurchmesser des Durchgangslochs (14d) kleiner als der Außendurchmesser des Anschlussmittels (15, 16) ist.

8. Leistungshalbleitermodul nach einem der vorangehenden Ansprüche,
**dadurch gekennzeichnet,**
**dass** der Gehäusedeckel (13) an seiner unteren Stirnseite Dichtungsstege aufweist.

9. Leistungshalbleitermodul nach einem der vorangehenden Ansprüche,
**dadurch gekennzeichnet,**
**dass** die Dichtungseinrichtung (14) zwischen der unteren Stirnseite des Gehäusedeckels (13) und der oberen Stirnseite des Gehäuses (11) mit Quetschsitz angeordnet ist.

10. Leistungshalbleitermodul nach einem der vorangehenden Ansprüche,
**dadurch gekennzeichnet,**
**dass** das Gehäuse (11) eine umlaufende Randwulst aufweist, in deren Innenraum die Grundplatte (14p) der Dichtungseinrichtung (14) einlegbar ist.

## Claims

1. Power semiconductor module or drive module therefor, comprising an electronic power circuit and a housing (11) with a housing lid (13), the housing lid (13) being penetrated by electrical and/or optical connecting means (15, 16),
**characterized in that**
between an upper end face (11o) of the housing (11) and a lower end face of the housing lid (13), an elastomeric sealing device (14) is arranged which has a baseplate (14p) and one or more cross-sectionally in each case trapezoidal sealing elements (14e) arranged on the baseplate (14p), the sealing elements (14e) corresponding to cross-sectionally trapezoidal recesses in the housing lid (13) and having in each case a head plate with at least one through-hole (14d) and the sealing elements (14e) being designed to be slotted, at least one slot (14s), starting from the foot section of the sealing element (14e) ending in the at least one through-hole (14d).

2. Power semiconductor module according to Claim 1,
**characterized in that**
the sealing elements (14e) are constructed integrally with the baseplate (14p).

3. Power semiconductor module according to one of the preceding claims,
**characterized in that**
the sealing elements (14e) are designed as hollow bodies.

4. Power semiconductor module according to one of the preceding claims,
**characterized in that**
the connecting means (15, 16) are designed to be wire-shaped with circular cross-section.

5. Power semiconductor module according to one of Claims 1 to 3,
**characterized in that**
the connecting means (15, 16) are designed to be ribbon-shaped with rectangular cross-section.

6. Power semiconductor module according to one of the preceding claims,
**characterized in that**
the at least one through-hole (14d) has a cross-section which corresponds to the cross-section of the connecting means (15, 16) penetrating the at least one through-hole (14d).

7. Power semiconductor module according to one of the preceding claims,
**characterized in that**
the inside diameter of the through-hole (14d) is smaller than the outside diameter of the connecting means (15, 16).

8. Power semiconductor module according to one of the preceding claims,
**characterized in that**
the housing lid (13) has sealing webs on its lower end face.

9. Power semiconductor module according to one of the preceding claims,
**characterized in that**
the sealing device (14) is arranged with crimped seating between the lower end face of the housing lid (13) and the upper end face of the housing (11).

10. Power semiconductor module according to one of the preceding claims,
**characterized in that**
the housing (11) has a peripheral edge bead, into the internal space of which the baseplate (14p) of the sealing device (14) can be inserted.

## Revendications

1. Module semi-conducteur de puissance ou module de commande pour ce dernier, comprenant un circuit électronique de puissance et un boîtier (11) doté d'un couvercle (13) de boîtier, le couvercle (13) de boîtier étant traversé par des moyens (15, 16) de raccordement électrique et/ou optique,
**caractérisé en ce que**
un dispositif (14) de joint d'étanchéité en élastomère qui présente une plaque de base (14p) et un ou plusieurs éléments d'étanchéité (14e) de section transversale trapézoïdale disposés sur la plaque de base (14p) est disposé entre le côté frontal supérieur (11o) du boîtier (11) et la surface frontale inférieure du couvercle (13) du boîtier,
**en ce que** les éléments d'étanchéité (14e) correspondent à des découpes de section transversale trapézoïdale du couvercle (13) du boîtier et présentent chacun une plaque de tête dotée d'au moins un trou de passage (14d),
**en ce que** les éléments d'étanchéité (14e) sont fendus et
**en ce qu'**au moins une fente (14s) partant de la partie de pied de l'élément d'étanchéité (14e) se termine dans le ou les trous de passage (14d).

2. Module semi-conducteur de puissance selon la revendication 1, **caractérisé en ce que** les éléments d'étanchéité (14e) sont formés d'un seul tenant avec la plaque de base (14p).

3. Module semi-conducteur de puissance selon l'une des revendications précédentes, **caractérisé en ce que** les éléments d'étanchéité (14e) sont configurés comme corps creux.

4. Module semi-conducteur de puissance selon l'une des revendications précédentes, **caractérisé en ce que** les moyens de raccordement (15, 16) sont configurés en forme de fil de section transversale circulaire.

5. Module semi-conducteur de puissance selon l'une des revendications 1 à 3, **caractérisé en ce que** les moyens de raccordement (15, 16) sont configurés en forme de ruban de section transversale rectangulaire.

6. Module semi-conducteur de puissance selon l'une des revendications précédentes, **caractérisé en ce que** le ou les trous de passage (14d) présentent une section transversale qui correspond à la section transversale du moyen de raccordement (15, 16) qui traverse le ou les trous de passage (14d).

7. Module semi-conducteur de puissance selon l'une des revendications précédentes, **caractérisé en ce que** le diamètre intérieur du trou de passage (14d) est plus petit que le diamètre extérieur du moyen de raccordement (15, 16).

8. Module semi-conducteur de puissance selon l'une des revendications précédentes, **caractérisé en ce que** le couvercle (13) du boîtier présente des nervures d'étanchéité sur son côté frontal inférieur.

9. Module semi-conducteur de puissance selon l'une des revendications précédentes, **caractérisé en ce que** le dispositif d'étanchéité (14) est disposé entre le côté frontal inférieur du couvercle (13) du boîtier et le côté frontal supérieur du boîtier (11) et y est écrasé.

10. Module semi-conducteur de puissance selon l'une des revendications précédentes, **caractérisé en ce que** le boîtier (11) présente une bordure périphérique en bourrelet dans l'espace intérieur de laquelle la plaque de base (14p) du dispositif d'étanchéité (14) peut être placée.
